# EUROPEAN PATENT SPECIFICATION

(11) **EP 3 943 321 B1**
(45) Date of publication and mention of the grant of the patent: **29.07.2026**
(21) Application number: 21181214.4
(22) Date of filing: 23.06.2021
(51) Int. Cl.: B60H 1/00, F25D 11/00, B60H 1/32, F25B 25/00, F25B 40/02, F25B 49/02, F25D 21/12

(54) **INTEGRATED HEATING AND COOLING SYSTEM AND METHOD FOR TRANSPORTATION REFRIGERATION UNIT**
INTEGRIERTES HEIZ- UND KÜHLSYSTEM UND -VERFAHREN FÜR TRANSPORTKÜHLEINHEIT
SYSTÈME DE CHAUFFAGE ET DE REFROIDISSEMENT INTÉGRÉ ET PROCÉDÉ POUR UNITÉ DE RÉFRIGÉRATION DE TRANSPORT

(30) Priority: 23.07.2020 US 202062705925 P
(43) Date of publication of application: 26.01.2022
(73) Proprietor: Carrier Corporation, Palm Beach Gardens, FL 33418 (US)
(72) Inventor: PERKOVICH, Mark J., Syracuse (US)
(74) Representative: Dehns

(56) References cited:
- EP-A2- 3 012 133
- EP-A2- 3 069 910
- WO-A1-2018/226649
- US-A1- 2017 008 407

## Description

The present invention relates to a transportation refrigeration system, and in preferred embodiment is concerned with a system and method for controlling the temperature of a heat source in a transportation refrigeration unit.

Traditional refrigeration cargo trucks or refrigerated tractor trailers, such as those used to transport cargo via sea, rail or road, typically include a cargo compartment modified to include a refrigeration system located at one end of the truck, trailer, or cargo container. Refrigerator systems typically include a compressor, a condenser, an expansion valve, and an evaporator serially connected by refrigerant lines in a closed refrigerant circuit. A power unit, such as a combustion engine, drives the compressor of the refrigeration unit and may be diesel powered, natural gas powered, or other type of engine. In many tractor trailer transportation refrigeration systems, the compressor is driven by the engine shaft either through a belt drive or by a mechanical shaft-to-shaft link. In other systems, the engine of the refrigeration unit drives a generator that generates electrical power, which in-turn, drives the compressor.

Trucks, trailers or engineless transportation refrigeration units (TRU) that use electric drive systems, including hybrid systems that may combine an internal combustion engine and an electric motor powered by an energy storage device (e.g., battery), may have one or more power electronics packages (PEP) on board. As power demands on the electrical systems in alternative fuel vehicles and TRUs increase, there is an ever increasing need to maximize efficiency and reliability of such systems. Additionally, there is a constant desire to reduce cost and space required by the components within the electrical system in order to minimize the overall cost and weight of vehicles and TRUs.

EP 3 069 910 A2 discloses an electric vehicle thermal management system and electric vehicles using the thermal management system. A passenger cabin is heated by the heat dissipated from a battery and /or a motor. A cooling circuit in the management system fluidly connects the battery, the motor and a first radiator in series. The first radiator provides a heat source to the passenger cabin by means of the heat dissipated from the battery and/or the electric motor. Under certain conditions, the electric motor is selectively separated from the cooling circuit, so that when the passenger cabin needs to be heated, the thermal management system can provide heat to the passenger cabin without affecting the heat dissipation of the battery.

In general, PEPs include systems and components for controlling and converting electrical power. For example, alternative fuel vehicles may include only direct current (DC) power supplies, direct current-to-alternating current (DC/AC) inverters (or power inverters) to convert DC power to AC power, which is generally required by the motor. Such vehicles, particularly fuel cell vehicles, also often use two separate voltage sources, such as a battery and a fuel cell, to power the electric motors that drive the wheels. Thus power converters, such as direct current-to-direct current (DC/DC) converters, are typically also provided to manage and transfer the power from the two voltage sources.

PEPs require temperature management because extreme temperatures, either hot or cold, can affect component and system operation and reliability. Current systems may address PEP cooling by equipping a PEP with extended fin surfaces for cooling, generally aided by forced air convection over the fins. However, forced air circulation over the PEP increases the risk that condensate will accumulate inside or outside the power electronics enclosure which can damage to the PEP systems and components, and does not address the need to keep a PEP heated in cold environments. What is needed then, is an improved system and method for managing the heating and/or cooling of a PEP.

As refrigeration cargo trucks, trailers and containers are increasingly powered, in whole or in part, by power electronics systems and components, a need exists to regulate the temperature of such systems such as PEPs, for example in order to ensure safe and reliable operation. The PEP generates heat as it supplies power to a truck and/or container. This heat must be dissipated to avoid overheating and damaging PEP systems and components. In other instances, it may be desirable to add heat to the PEP, as in cold climates, to ensure continued reliable operation. Disclosed below is a system and method for heating and/or cooling the PEP using a temperature control system that uses a controller and a pump to circulate a heat transfer fluid in two closed-loop circuits, with the PEP, a heat source, operably coupled to one of the flow circuits. The transfer control system, which is operably coupled to an evaporator, provides various means of heating or cooling the PEP under different operating conditions as further described below.

According to first aspect, the invention provides a transportation refrigeration system according to claim 1.

According to another aspect, the invention provides a temperature control system according to claim 9.

Viewed from a further aspect, the invention provides a method according to claim 10.

Certain embodiments will be described by way of example only and with reference to the accompanying drawings. The accompanying drawings form a part of the specification. Throughout the drawings, like reference numbers identify like elements.
FIG. 1 illustrates a transportation refrigeration system having an engineless transportation refrigeration unit (TRU).
FIG. 2 illustrates a transportation refrigeration unit.
FIG. 3 illustrates a portion of a transportation refrigeration unit.
FIG. 4 illustrates a method of operating a temperature control system.
FIG. 5 illustrates a control flow diagram of a temperature control system.
FIG. 6 illustrates a control flow diagram of a temperature control system.
FIG. 7 illustrates a control flow diagram of a temperature control system.
FIG. 8 illustrates a control flow diagram of a temperature control system.

These and other advantages and features will become more apparent from the A detailed description of one or more embodiments of the disclosed system and method are presented here by way of exemplification and not limitation with reference to the Figures.

In general, power electronics is technology associated with the efficient conversion, control and conditioning of electric power by static means from its available input form into a desired electrical output form. As discussed below, an engineless transportation refrigeration unit (TRU) 26 may be equipped with one or more power electric devices for controlling and converting electrical power. In one non-limiting embodiment, a power electronics package (PEP) may include power electronics devices that control the flow of electricity between one or more of a battery, a motor, a generator, a refrigeration transportation system, and a vehicle (e.g., truck) powertrain. In another non-limiting embodiment, a PEP may also include power sources, such as batteries, fuel cells, converters, inverters, and power semiconductor devices such as power diodes, thyristors, power transistors (e.g., MOSFET and IGBT). For example, a frequency converter may be included to regulate the speed of a compressor, or an inverter assembly, for example, may be included to convert DC power into AC power, before the power is sent to an electric motor.

Power electronics packages generate heat (e.g., a heat source), which must be temperature controlled as described below to ensure reliable operation. In addition, depending on where the TRU is located (e.g., stationary or in-transit) the PEP may be exposed to extreme environmental conditions (heat/cold). Therefore, in addition to removing heat, some circumstances may necessitate adding heat to the PEP to avoid damage or system failure.

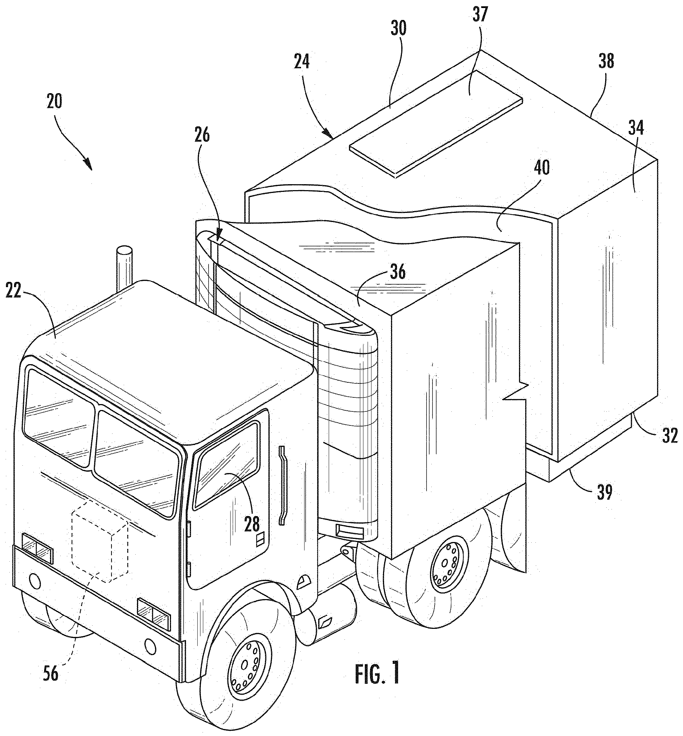

Referring to FIG. 1, a transportation refrigeration system 20 is illustrated. In the illustrated embodiment, the transportation refrigeration system 20 may include a tractor or vehicle 22, a container 24, and an engineless transportation refrigeration unit (TRU) 26. The container 24 may be pulled by vehicle 22. In some embodiments, the vehicle 22 and container 24 are attached (e.g., truck-trailer) with the TRU 26 attached to the container 24. It is understood that embodiments described herein may be applied to shipping containers that are shipped by rail, sea, air, or any other suitable container, thus the vehicle may be a truck, train, boat, airplane, helicopter, etc.

The vehicle 22 may include an operator's compartment or cab 28 and a combustion engine 56 which is part of the powertrain or drive system of the vehicle 22. The container 24 may be coupled to the vehicle 22 and is thus pulled or propelled to desired destinations. The trailer may include a top wall 30, a bottom wall 32 opposed to and spaced from the top wall 30, two side walls 34 spaced from and opposed to one another, and opposing front and rear walls 36, 38 with the front wall 36 being closest to the vehicle 22. The container 24 may further include doors (not shown) (e.g., at the rear wall 38). In addition, container 24 may further include a renewable power source 37 (e.g., solar panel) configured to, among other things, recharge batteries of an energy storage device 39. The walls 30, 32, 34, 36, 38 together define the boundaries of a cargo compartment 40.

Typically, transportation refrigeration systems 20 are used to transport and distribute cargo, such as, for example perishable goods and environmentally sensitive goods (herein referred to as perishable goods). The perishable goods may include but are not limited to fruits, vegetables, grains, beans, nuts, eggs, dairy, seed, flowers, meat, poultry, fish, ice, blood, pharmaceuticals, or any other suitable cargo requiring cold chain transport. In the illustrated embodiment, the TRU 26 is associated with a container 24 to provide desired environmental parameters, such as, for example, temperature, pressure, humidity, carbon dioxide, ethylene, ozone, light exposure, vibration exposure, and other conditions to the cargo compartment 40. In further embodiments, the TRU 26 is a refrigeration system capable of providing a desired temperature and humidity range.

The TRU 26 is generally integrated into container 24 and may be mounted to the front wall 36. The cargo is maintained at a desired temperature by cooling of the compartment 40 via the TRU 26 that circulates airflow into and through the cargo compartment 40 of container 24. It is further contemplated and understood that TRU 26 may be applied to any transport compartment (e.g., shipping or transport containers) and may not necessarily those used in tractor trailer systems. Furthermore, the transport container 24 may be a part of vehicle 22 or constructed to be removed from a framework and wheels (not shown) of container 24 for alternative shipping means (e.g., marine, railroad, flight, and others).

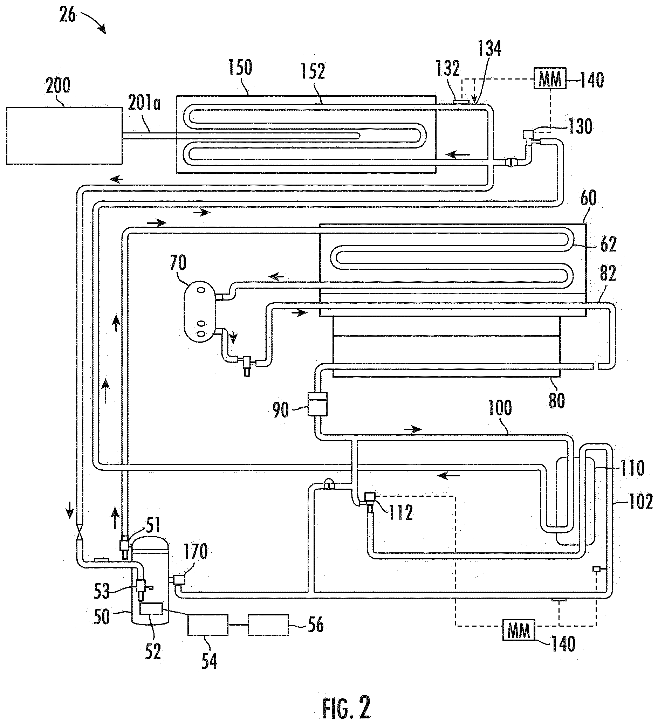

FIG. 2 is a schematic representation of a TRU 26. The TRU 26 may circulate a working fluid in a closed circuit, to control the temperature in a space, such as cargo compartment 40 of container 24. The working fluid may be a refrigerant or a mixture of refrigerant and a non-refrigerant or a blend thereof in gas, liquid or multiple phases ("refrigerant"). The refrigerant may be circulated to absorb and remove heat from the space and may subsequently reject the heat elsewhere. In some embodiments, the refrigerant may be a natural refrigerant, hydrofluorocarbon (HFC), HFC R-134a, R-404a, among others. The natural refrigerant may be CO₂, propane, ammonia, or other natural refrigerant that may include a global-warming potential (GWP) of about 1. It is understood that in these examples the transportation refrigeration system of FIG. 1 and the TRU 26, each as described below, generally describes a single stage vapor compression system.

Compressor 50 may be a single compressor, a two-stage compressor, a scroll-type compressor or other compressors adapted to compress the refrigerant. Other refrigerant systems may be a two-stage vapor compression system. Compressor 50 includes a motor 52 which may be an integrated electric drive motor driven by a generator 54, such as a synchronous generator. Generator 54 may be driven by an engine 56 of a vehicle that tows TRU 26. Alternatively, generator 54 may be driven by a stand-alone engine 56. In an exemplary embodiment, engine 56 is a diesel engine. The refrigerant exits the compressor 50 via discharge port 51, as a high temperature, high pressure vapor, and flows to a heat absorption heat exchanger (hereafter "condenser") 60 which may also be a gas cooler.

Refrigerant passes through the condenser 60 in a heat exchange relationship with a cooling medium, such as ambient air. Condenser 60, and optionally a subcooler 80 discussed below, may each include a refrigerant circuit 62, 82, which may include a plurality of condenser coil fins and/or tubes, which receive air, typically blown by a heat rejecting fan (not shown). By removing latent heat, the refrigerant condenses to a high pressure/high temperature liquid and flows to receiver 70 that provides storage for excess refrigerant during low temperature operation.

The refrigerant flows from receiver 70 to a subcooler 80, which increases refrigerant subcooling. Subcooler 80 may be positioned adjacent to the condenser 60 and cooled by air flow from a heat exchanger fan (not shown). The subcooler 80 may be a single-pass type subcooler, or as illustrated, a multi-pass type subcooler 80, such that refrigerant circuit 82 may be configured to make multiple passes through subcooler 80. The subcooler 80 may be fluidly connected to an economizer heat exchanger 110 via a filter-drier 90.

Filter-drier 90 keeps the refrigerant clean and dry, and outlets the refrigerant to a first flow path 100 of an economizer heat exchanger 110, which increases subcooling. Economizer heat exchanger 110 may be a plate-type heat exchanger, providing a refrigerant heat exchange between refrigerant flowing in the first flow path 100 and refrigerant flowing in second flow path 102.

From the first flow path 100, the refrigerant flows from the economizer heat exchanger 110 to a first expansion device 130. Expansion device 130 controls the ingress of the refrigerant to a heat rejection heat exchanger (hereafter, "evaporator") 150. Expansion device 130 is controlled by controller 140 in response to signals from the evaporator outlet temperature sensor 132 and evaporator outlet pressure sensor 134. An evaporator fan (not shown) draws or pushes air over evaporator 150 to condition the air in compartment 40. Refrigerant passing through evaporator 150 is refrigerant circuit 152 in heat exchange relation with a heating fluid (e.g., air), whereby the refrigerant is vaporized and typically superheated. Refrigerant exits the evaporator 150 and flows to the suction port 53 of the compressor 50.

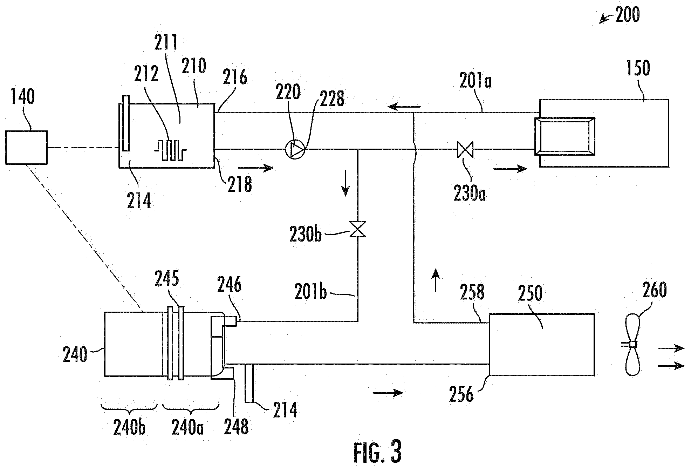

Controller 140 may be a single device, or a plurality of devices, microprocessor based, and may control various operations of the TRU 26 including compressor 50, expansion devices 112, 130, and temperature control system 200 as described below, including a fluid heating system 210, a pump 220, a heat transfer apparatus 240 of a heat source, and/or a fan 260, and may also receive input from various sensors, such as sensors 132, 134 and FIG. 3, 214, and user input devices. The controller 140 may have a memory configured to store, for example, plurality of predetermined limits or ranges further described below, and a processor operably coupled to the memory. The term "operably coupled" as used throughout means any direct or indirect connection to any other component(s).

Referring to FIG. 2, TRU 26 further includes a second flow path 102 connected through the economizer heat exchanger 110. The second flow path 102 is connected between the first flow path 100 and an intermediate inlet port 170 of compressor 50. The intermediate inlet port 170 is located at an intermediate location along a compression path between compression suction port 53 and compressor discharge port 51. A second expansion device 112 is positioned in the second flow path 102, upstream of the economizer heat exchanger 110. The second expansion device 112 may be an electronic economizer expansion device controlled by controller 140. When the economizer 110 is active, controller 140 controls the second expansion device 112 to allow the refrigerant to pass through the second flow path 102, through the economizer heat exchanger 110 and to intermediate inlet port 170. The second expansion device 112 serves to expand and cool the refrigerant, which proceeds into the economizer heat exchanger 110, thereby subcooling the refrigerant in the first flow path 100 proceeding to expansion device 130 and the second heat exchanger 150.

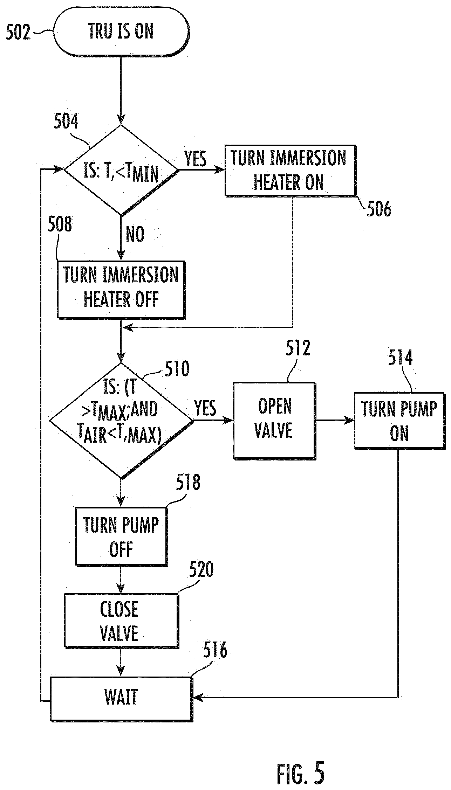

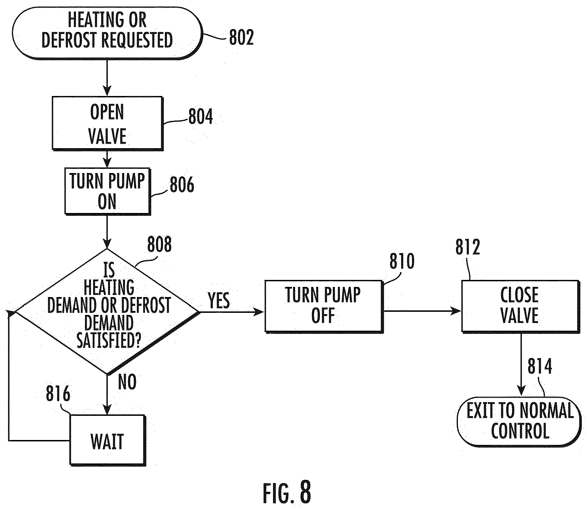

Referring to FIG. 3, a portion of a transportation refrigeration system 20, including a temperature control system 200, is illustrated. The TRU 26, may include a temperature control system 200 operably coupled to evaporator 150. Under certain operating conditions, the temperature control system 200 may provide heating or cooling of a heat source (see, FIGS. 5-7) and/or the heating (e.g., defrosting) of evaporator 150 and/or the cargo compartment 40 (see, FIG. 8).

The temperature control system 200 manages the temperature of the PEP using a controller 140 to operate various components of the temperature control system 200 to direct the second working fluid to circulate in a closed-flow circuit, including a first flow circuit and a second flow circuit, as described below. The temperature control system 200 may include a fluid heating system 210, operably coupled to a pump 220 having a discharge port 228 for circulating the second working fluid in a closed-circuit flow circuit including a first flow circuit 201a and a second flow circuit 201b. Under certain operating conditions described below, the second working fluid may flow serially from fluid heating system 210 outlet 218, to pump 220 and valve 230a in the first flow circuit 201a returning to the fluid heating system 210 through inlet port 216.

Under certain other operating conditions described below, the second working fluid may flow serially in a second flow circuit 201b, from fluid heating system 210, through pump 220 then to valve 230b, to heat transfer apparatus 240 via inlet port 246 and exit outlet port 248, to a radiator 250, returning to fluid heating system 210 through inlet 216. The second flow circuit 201b may also include a fan 260, which may be positioned adjacent to radiator 250. When the second working fluid flows in the second flow circuit 201b, the second working fluid may be in a heat exchange relationship with at least one of heat source and the heat transfer apparatus 240, as discussed below. In addition, as the second working fluid flows through radiator 250, the second working fluid may be in a heat exchange relationship with a cooling medium, such as ambient air and/or with air supplied by the operation of fan 260.

The fluid heating system 210 may include an electric heater 212 (e.g., electric immersion heater). The electric heater 212 may have an internal volume that may serve, in part, as a reservoir 211 for the second working fluid. In addition, the fluid heating system 210 may also include an element for heating, and a sensor 214 for sensing the temperature of, the second working fluid. The second working fluid may include an organic compound such as a water-propylene glycol mixture or a water-ethylene glycol mixture, or any other suitable compound or mixture that is useful as a second working fluid.

The fluid heating system 210 and/or the heat transfer apparatus 240, may be electrically connected to controller 140. As further described below, controller 140 may be configured to communicate with a sensor 214 associated with the fluid heating system 210 and/or the heat transfer apparatus 240, for determining the temperature of at least one of the second working fluid and the heat source. The controller 140 may be further configured to have stored therein, a plurality of predetermined operating condition limit and/or ranges based on at least one of the temperature of the second working fluid, the evaporator coil and the cargo compartment 40, and/or an evaporator air pressure drop, such that when such operating condition limits or ranges are compared to a measured operating condition, the controller 140 actuates at least one of the fan 260, and/or valve 230a to permit the second working fluid to flow in the first flow circuit 201a, and valve 230b to permit the second working fluid to flow in the second flow circuit 201b. In some embodiments, when sensor 214 is configured to measure temperature, sensor 214 may include digital temperature sensors, negative temperature coefficient (NTC) thermistors, resistance temperature detectors (RTD), and thermocouple sensors.

The heat transfer apparatus 240 includes an assembly having a first portion 240a, a second portion 240b, and a heat sink 245 disposed between the first portion 240a and the second portion 240b. Each of the first portion 240a, the second portion 240b and the heat sink 245 may be configured to operably couple together. In general, the shape and dimension of the heat transfer apparatus 240 may vary depending on a variety of factors, including the dimensions of the fluid heating system 210 and the heat source, and the amount of heat to be dissipated from the heat source. Any one of the first portion 240a, the second portion 240b and/or heat sink 245 may be made of any suitable material, including metal and/or plastics.

The first portion 240a of heat transfer apparatus 240 may be configured to permit the second flow circuit 201b to pass through the first portion 240a. For example, the first portion 240a may have a channel having a proximal end for receiving the second flow circuit 201b through an inlet port 246 permitting the second working fluid to be in heat exchange relationship with heat sink 245, and a distal end having an outlet port 248 to permit the second working fluid to flow to the radiator 250. The second flow circuit 201b may be operably coupled to an exterior surface of the heat transfer apparatus 240 (not shown) permitting the second working fluid to be in a heat exchange relationship with the heat transfer apparatus 240, including heat sink 245. For example, the flow circuit 201a, 201b may be arranged in a serpentine pattern along a surface of the heat transfer apparatus 240, or may be adjacent to the heat source.

The second portion 240b of heat transfer apparatus 240 may be configured to have an internal volume that may be useful for housing the heat source. For example, the second portion 240b may include a lid that is openable to allow easy access to the heat source, seals to provide a leak-free and dust free environment, and insulation to provide protection from extreme external temperatures, such extreme heat or cold when the TRU 26 is located in an extreme climate. In an alternate embodiment, the second portion 240b may be operably coupled to the heat source.

The heat transfer apparatus 240 may include a sensor 214 for determining the temperature of the heat transfer apparatus 240, the heat source or the second working fluid. The location of sensor 214 is shown for illustrative purposes only, and may be operably coupled, or adjacent to the heat transfer apparatus 240 or may be positioned downstream from the heat source and/or the heat transfer apparatus.

The temperature control system 200 may also include a radiator 250. During operation, the second working fluid may exit the heat transfer apparatus 240 through outlet port 248 and enter radiator 250 through inlet 256. Radiator 250 may include one or more devices, such as pipes, tubes, fins, for circulating the second working fluid therethrough and to permit a heat exchange to occur between the second working fluid and a cooling medium, such as air, before exiting through outlet port 258 and returning to the fluid heating system 210. A fan 260 adjacent to radiator 250 may be in communication with controller 140 to reject heat from the radiator 250 to ambient air under certain operating conditions described below.

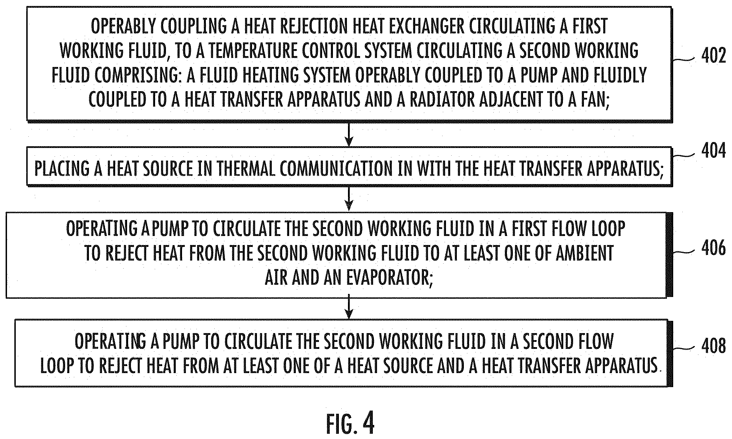

Referring to FIG. 4, a method for operating a temperature control system 200 to regulate the temperature of a heat source is shown. The heat source may include a power electronics package, which may include one or more power electronic devices such as converters, inverters, and power semiconductor devices that may also include power diodes, thyristors, power transistors (e.g., MOSFET and IGBT) for providing power to the transport refrigeration system 20. The heat source may also include power sources as described above. The heat source may be operably coupled, or adjacent, to a heat transfer apparatus 240. In some embodiments, the heat transfer apparatus 240 may be configured to have an internal volume that may be useful for housing the heat source.

Turning to FIGS. 4-8, the temperature control system 200 provides a method for direct or indirect heating and/or cooling of a heat source via flow circuit 201b, and/or for adding heat to cargo compartment 40 or for adding heat to evaporator 150 for defrosting, via flow circuit 201a. For each of the methods described below, the controller 140 may operate to circulate the second working fluid in the first or second flow circuit (201a, 201b) dependent on a plurality of predetermined temperature and/or operating condition limits or ranges for each described method. For example, for the methods described in FIGS. 5-8 controller 140 may be configured to store a plurality of predetermined temperature limits and/or ranges, which temperature limits or ranges may differ by method, depending on the desired result (i.e., heating, defrosting, cooling, etc.). As described below, the predetermined temperature limit or range may relate to the temperature of at least one of the second working fluid or ambient air. In the method described in FIG. 8, the predetermined limit or range may relate to operating condition limits, such as the temperature of, or pressure drop across the evaporator 150, and/or the temperature of the cargo compartment 40.

Turning to FIG. 4, the method begins at step 402 with an operational transportation refrigeration system such as TRU 26 having an evaporator 150 circulating a first working fluid (e.g., refrigerant) in a closed refrigerant circuit, operably coupled to a temperature control system 200 circulating a second working fluid (e.g., a water-propylene glycol mixture or a water-ethylene glycol mixture) in a closed circuit. As described above, the temperature control system 200 includes a fluid heating system 210 operably coupled to a pump 220 for circulating the second working fluid in a first flow circuit 201a having a valve 230a, and in a second flow circuit 201b having a valve 230b. Downstream from the heat transfer apparatus 240 may be a radiator 250 adjacent to a fan 260 for rejecting heat from the second working fluid flowing through the radiator 250, to ambient air before the second working fluid returns to fluid heating system 210 to complete the second flow circuit 201b.

In step 404, the method includes operably coupling a heat transfer apparatus 240 adjacent to a heat source, to the second flow circuit, thereby placing the heat source in thermal communication with the second working fluid. As discussed above, the heat source may include the power electronics package (PEP) which may also include one or more power sources (e.g., batteries, fuel cells).

In step 406, the method includes operating a controller to circulate the second working fluid in the first flow circuit 201a, to maintain the temperature of the second working fluid within a predetermined temperature range to prevent the second working fluid from overheating, the predetermined temperature range, having a lower temperature limit and an upper temperature limit. This method is further described in reference to FIG. 5, below.

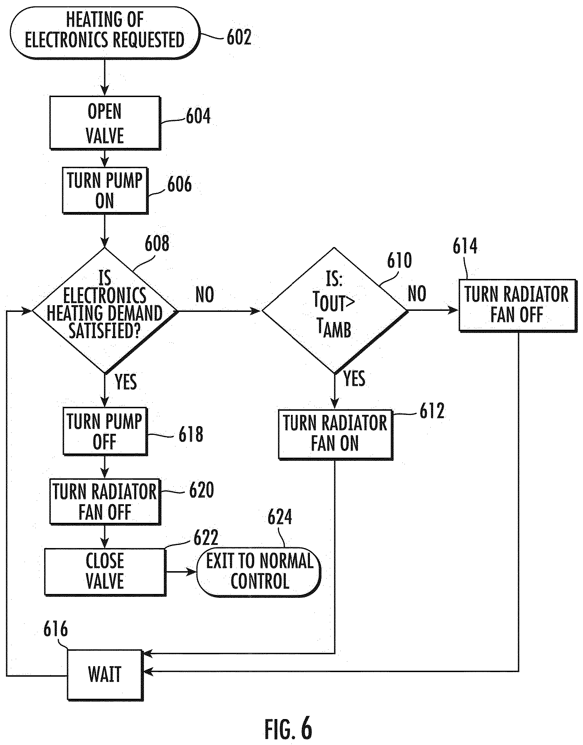

In step 408, the method includes providing heat to the heat source directly or indirectly as described below. The method includes operating a controller 140 to circulate the second working fluid in the second flow circuit 201b to reject heat from the second working fluid to at least one of the heat transfer apparatus 240 and the heat source, when heating of the heat transfer apparatus 240 is requested by controller 140, and the temperature of the second working fluid is less than a predetermined temperature limit, which may be different from the temperature limit or range of step 406. The method includes obtaining the temperature of the second working fluid from a sensor 214 downstream from the heat transfer apparatus 240, which provides as an indication of temperature of the heat source. This method is further described in reference to FIG. 6, below.

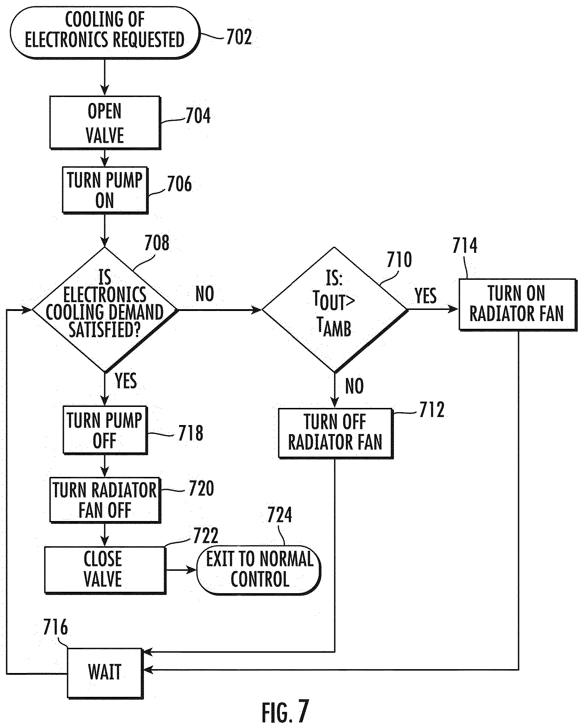

In step 410, the method includes operating a controller 140 to circulate the second working fluid in the second flow circuit 201a to reject heat from at least one of the heat source and the heat transfer apparatus 240 to the second working fluid when cooling of the heat transfer apparatus is requested by controller 140. This method is further described in reference to FIG. 7, below.

In step 412, the method includes operating the controller 140 to circulate the second working fluid in the first flow circuit 201a to reject heat from the second working fluid to at least one of the evaporator 150 and the cargo compartment 40 based certain predetermined operating condition limits, such as evaporator coil temperature, as further described in reference to FIG. 8, below.

A method of operating a transportation refrigeration unit 20 will now be described. The method shown in FIG. 5 can be implemented in and will be described using a controller 140. The controller 140 function steps are indicated with rectangles, whereas the logic steps or questions, are shown within diamond-shaped parallelograms. The flow chart of FIG. 5, or condition(s) operations blocks 502-520 can be performed periodically, repeatedly, continuously, upon operation action or responsive to sensed criteria.

The method begins at step 502 when TRU 26 is operational. The method includes maintaining the temperature of the second working fluid in the reservoir 211 within a predetermined temperature range having a lower temperature limit and an upper temperature limit, for example, ≥ 80 °F (≥ about 27 °C) and ≤ 90 °F (≥ about 32 °C). The lower temperature limit may be related to the temperature of the second working fluid, which may be obtained by the controller 140 from one or more temperature sensors 214 coupled to the temperature control system 200. The upper temperature limit may be related to ambient air temperature, which may be obtained by the controller 140 from sensors 214, or one or more other sensors associated with operator compartment 26, the cargo compartment 40, the temperature of the first working fluid, or components of the refrigeration unit 26.

In step 504, the controller 140 determines if the temperature of the second working fluid in the reservoir 211 as measured by a temperature sensor 214 coupled to the fluid heating system 211, is less than a predetermined minimum temperature. This predetermined minimum temperature may include the manufacturer's recommended minimum temperature for the second working fluid. If the temperature of the second working fluid is less than the predetermined minimum temperature, the controller 140 operates to turn on the electric heater 212.

Next, in step 510, the controller 140 operates to maintain the temperature of the second working fluid in within a predetermined temperature range; for example, between a lower temperature of 80 °F (about 27 °C), and a maximum temperature of 90°F (about 32 °C). If the temperature of the second working fluid in the reservoir is greater than the upper temperature limit (e.g., 90 °F, or about 32 °C), then the controller operates to open valve 230a and turn on the pump 220 in steps 512, 514, to permit the second working fluid to reject heat to the evaporator 150 which, during normal operation will have a temperature that is lower than then temperature of the second working fluid. Thereafter, in step 516, the controller 140 may be configured for a time delay (e.g., 1 second), before returning to step 504. The controller 140 may repeat the preceding steps until the condition described in step 510 is false. When the condition described at step 510 is false, the controller 140 may turn pump 220 off (step 518), closes valve 230a (step 520) and may proceed to the time-delay step 516 before repeating the cycle, until the TRU 26 is turned off.

A method of operating a transportation refrigeration unit 20 will now be described. The method shown in FIG. 6, can be implemented in and will be described using a controller 140. The flow chart of FIG. 6, or condition(s) operations blocks 602-624 may be performed periodically, repeatedly, continuously, upon operation action or responsive to sensed criteria.

Referring to FIG. 6, the method begins at step 602 with a call for heating the heat source. In The second working fluid may reject its heat to at least one of the heat transfer apparatus 240 and/or the heat source by circulating the second working fluid in the second flow circuit 201b. This may be desirable under certain operating conditions such as when the TRU 26 may be stationary or in-transit in a cold climate. The first part of the method is similar to the method described in FIG. 5, in that it avoids overheating the second working fluid. The second part of the method allows the second working fluid to circulate in the second flow circuit 201b thereby allowing the second working fluid to reject its heat to at least one of the heat source and the heat transfer apparatus as described below.

Upon receiving a call for heat, the controller 140 may actuate (open) valve 230b, in step 604, and turn on pump 220 in step 606 to allow the second working fluid to circulate in the second flow circuit 201b. The controller 140 determines whether circulating the second working fluid in the second flow circuit satisfies the need for heat in step 608. If not, then in step 610, the controller compares the temperature of the second working fluid to ambient air temperature. The temperature of the second working fluid may be determined from a sensor 214, downstream from the heat source, or a sensor 214 operably coupled to the fluid heating system 210 for determining the temperature of the second working fluid in reservoir 211. Optionally, the temperature of the second working fluid is greater than the predetermined upper temperature limit of at least one of ambient air and the reservoir 211, then in step 612, the controller 140 may actuate (turn on) the fan 260 adjacent to radiator 250. In this step, heat is rejected to ambient air to prevent the reservoir 211 from overheating. In addition, if the temperature of the second working fluid is less than a predetermined lower temperature limit of at least one of the ambient temperature, and the reservoir 211, then in step 614, the fan 260 is turned off. In this step, the fan is turned off to permit the second working fluid to reject heat to at least one of the heat source and the heat transfer apparatus 240. This step also avoids overcooling the second working fluid. In step 616, whether the fan 260 is turned on or off, the controller 140 may be configured to proceed to a time-delay step 616, before returning to step 608 to determine if the heat source demand is satisfied.

Returning to step 608, if the heat source demand condition is met, then in steps 618-622, the controller 140 is configured to turn off pump 220, turn off the fan 260 adjacent to radiator 250, close valve 230b, and in step 624, the controller 140 exits to normal control.

A method of operating a transportation refrigeration unit 20 will now be described. The method shown in FIG. 7, can be implemented in and will be described using a controller 140. The flow chart of FIG. 7, or condition(s) operations blocks 702-724 may be performed periodically, repeatedly, continuously, upon operation action or responsive to sensed criteria.

Referring to FIG. 7, the method begins at step 702 with a call for cooling the heat source. Under certain operating conditions it may be desirable to initiate a call to controller 702 for cooling the heat source such as when the TRU 26 may be stationary or in-transit in an extremely hot climate. In this embodiment the controller 140 determines the temperature of the second working fluid, for example, as it exits the heat transfer apparatus 240 via a temperature sensor 214 positioned downstream of the heat transfer apparatus. The controller compares the temperature of the second working fluid as it exits the heat transfer apparatus 240 against a predetermined temperature limit, such as ambient air temperature. In one-limiting embodiment, if the temperature of the second working fluid is greater than a predetermined ambient air temperature limit, then the controller 140 may operate to direct the second working fluid in the second flow circuit 201b, and operate a fan 260 adjacent to radiator 250.

In one non-limiting embodiment, the method begins with step 702 upon receiving a call for cooling, wherein the controller 140 may actuate (open) valve 230b in step 704, and turn on pump 220, in step 706. If, in step 708, the cooling demand has not been satisfied, the controller compares in step 710, the temperature of the second working fluid to the ambient air temperature. The ambient air temperature may be provided by a sensor 214 located with the TRU 26, including the temperature control system 200, in communication with controller 140. If, for example, the temperature of the second working fluid as it exits the heat transfer apparatus is 90 °F and measured ambient temperature is 80 °F, then in addition to circulating the second working fluid in the second flow circuit, the controller will also turn on a fan 260 adjacent to radiator 250 to further reject heat to the ambient air. After running the fan, the controller may undergo a time-delay (e.g., 1 second) in step 716 before returning to step 708, where the cycle may repeat until either the demand for cooling is satisfied (step 708), or the temperature of the second working fluid at step 710 is less than the ambient temperature, in which event, the fan is turned off in step 712 and the controller may undergo a time delay (step 716). If after returning to step 708, the controller determines that the demand for cooling is satisfied, then in steps 718-722, the controller 140 is configured to turn off pump 220, turn off the fan 260, close valve 230b, and in step 724, the controller 140 exits to normal control.

A method of operating a transportation refrigeration unit 20 will now be described. The method shown in FIG. 8, can be implemented in and will be described using a controller 140. The flow chart of FIG. 8, or condition(s) operations blocks 802-816 may be performed periodically, repeatedly, continuously, upon operation action or responsive to sensed criteria.

Referring to FIG. 8, the method begins at step 802 with a call for heating the cargo compartment 40 or defrosting the evaporator 150. In this example, the controller 140 may circulate the second working fluid via the first flow circuit 201a the controller determines that one or more predetermined operating condition limits have been exceeded. A call for heating and/or defrosting may be requested by the controller 140 or manually (e.g., by an operator) based on a plurality of operating conditions, e.g., temperature of the cargo compartment 40, temperature of the evaporator coil, air pressure drop across the evaporator 150, or a time-based algorithm. Upon receiving a call for heating or defrosting, the controller 140 may actuate (open) valve 230a, in step 804, and turn on pump 220 in step 806, to permit the second working fluid to flow through the first flow circuit 201a and exchange heat between second working fluid with at least one of, the evaporator 150 and/or the cargo compartment 40. When the need for heating or defrosting is satisfied, then in step 810, the controller 140 turns pump 220 off, and in step 812, closes valve 230a in the first flow circuit 201a and exits to normal control in step 814. If the demand for heating and/or defrosting is not satisfied, then the controller 140 may be configured to proceed to a time-delay (e.g., 1 second) in step 816, before returning to step 808, until the heating and/or defrosting demand is satisfied.

While the present disclosure has been described with reference to an exemplary embodiment or embodiments, it will be understood by those skilled in the art that various changes may be made without departing from the scope of the present invention, which is defined by the claims. In addition, many modifications may be made to adapt a particular situation or material to the teachings of the present disclosure without departing from the scope of the invention, as defined by the claims. Therefore, it is intended that the present invention not be limited to the particular embodiment disclosed as the best mode contemplated for carrying out this present invention, but that the present invention will include all embodiments falling within the scope of the claims.

## Claims

1. A temperature control system (200) comprising:
a fluid heating apparatus (210) operably coupled to a pump (220) configured to circulate a temperature control system working fluid by a first flow circuit (201a) and a second flow circuit (201b),
wherein the first flow circuit (201a) is fluidly coupled to a heat absorption heat exchanger (150), and
wherein the second flow circuit (201b) is fluidly coupled to a heat transfer apparatus (240) comprising a first portion (240a), a second portion (240b), and a heat sink (245) disposed between the first portion and the second portion, the second portion (240b) of the heat transfer apparatus (240) comprising a heat source, and wherein the second flow circuit (201b) is fluidly coupled to a radiator (250) that is fluidly coupled to a fan (260).

2. The temperature control system of claim 1, wherein the heat absorption heat exchanger comprises a circulating refrigerant.

3. The temperature control system of claim 1 or 2, wherein the temperature control system working fluid comprises an organic compound, selected from a group consisting of a water-propylene glycol mixture or a water-ethylene glycol mixture.

4. The temperature control system of claim 1, 2 or 3, comprising a controller (140) in communication with the at least one of the fluid heating apparatus, the pump, the fan, a first valve (230a) in the first flow circuit and a second valve (230b) in the second flow circuit.

5. The temperature control system of any preceding claim, wherein the fluid heating apparatus comprises an electric immersion heater (212).

6. The temperature control system of any preceding claim, wherein the first portion has disposed therein at least two plates operably coupled together in parallel, forming a flow channel between adjacent plates.

7. The temperature control system of any preceding claim, wherein the heat source comprises a power electronics package.

8. The temperature control system of claim 7, wherein the power electronics package comprises at least one of a power semiconductor device, a converter, an inverter, a battery, and a fuel cell.

9. A transportation refrigeration system (20) comprising:
a compressor (50) having a suction port (53) and a discharge port (51) configured to circulate a refrigeration flow circuit working fluid through a refrigeration flow circuit;
a heat absorption heat exchanger (60) operably coupled to the compressor discharge port; and
a temperature control system as claimed in any preceding claim, wherein the radiator is adjacent to the fan.

10. A method for regulating the temperature of a heat source, the method comprising:
operably coupling an evaporator (150) circulating a first working fluid, to a temperature control system (200) comprising a fluid heating apparatus (210) operably coupled to a pump (220), for circulating a second working fluid in a first flow circuit (201a) and a second flow circuit (201b), and a controller (140) having stored therein a plurality of limits or ranges for operating the temperature control system;
operably coupling a heat transfer apparatus (240) to the second flow circuit, the heat transfer apparatus comprising a first portion (240a), a second portion (240b), and a heat sink (245) disposed between the first portion and the second portion of the heat transfer apparatus (240) comprising a heat source;
operating the controller to circulate the second working fluid in the first flow circuit and to maintain the temperature of the second working fluid within a predetermined temperature range having an upper limit and a lower limit;
operating the controller to circulate the second working fluid in the second flow circuit and to reject heat from the second working fluid to at least one of the heat transfer apparatus and the heat source, when the temperature of at least one of the second working fluid and the ambient air is less than a predetermined lower temperature limit;
operating the controller to circulate the second working fluid in the second flow circuit to reject heat from at least one of the heat source and the heat transfer apparatus to the second working fluid when the temperature of the second working fluid is greater than a predetermined ambient air temperature limit; and
operating the controller to circulate the second working fluid in the first flow circuit to reject heat from the second working fluid to at least one of the evaporator and a cargo compartment, when at least one predetermined operating condition limit is exceeded.

11. The method of claim 10, wherein the controller operates an electric heater (212) when the temperature of the second working fluid is less than the lower limit of a predetermined temperature range.

12. The method of claim 11, wherein the controller operates to permit the second working fluid to reject heat to the evaporator, and turn off the electric heater, when the temperature of the second working fluid is greater than the upper limit of the predetermined temperature range.

13. The method of claim 10, 11 or 12, wherein the controller operates a fan (260) to reject heat from the second working fluid when the temperature of the second working fluid is greater than a predetermined upper temperature limit of at least one of ambient air and a reservoir (211).

14. The method of any of claims 10 to 13, wherein the predetermined operating condition limit is selected from a group consisting of a cargo compartment temperature limit, an evaporator coil temperature limit, an evaporator air pressure limit, or a time limit.

## Patentansprüche

1. Temperatursteuersystem (200), umfassend:
eine Fluidheizeinrichtung (210), die operativ mit einer Pumpe (220) gekoppelt ist, die konfiguriert ist, um ein Temperatursteuersystem-Arbeitsfluid durch einen ersten Strömungskreislauf (201a) und einen zweiten Strömungskreislauf (201b) zu zirkulieren,
wobei der erste Strömungskreislauf (201a) mit einem Wärmeaufnahme-Wärmetauscher (150) fluidisch gekoppelt ist, und
wobei der zweite Strömungskreislauf (201b) mit einer Wärmeübertragungseinrichtung (240) fluidisch gekoppelt ist, die einen ersten Teil (240a), einen zweiten Teil (240b) und eine Wärmesenke (245) umfasst, die zwischen dem ersten Teil und dem zweiten Teil angeordnet ist, wobei der zweite Teil (240b) der Wärmeübertragungseinrichtung (240) eine Wärmequelle umfasst, und wobei der zweite Strömungskreislauf (201b) mit einem Kühler (250) fluidisch gekoppelt ist, der mit einem Ventilator (260) fluidisch gekoppelt ist.

2. Temperatursteuersystem nach Anspruch 1, wobei der Wärmeaufnahme-Wärmetauscher ein zirkulierendes Kältemittel umfasst.

3. Temperatursteuersystem nach Anspruch 1 oder 2, wobei das Temperatursteuersystem-Arbeitsfluid eine organische Verbindung umfasst, die aus einer Gruppe ausgewählt ist, die aus einer Wasser-Propylenglykol-Mischung oder einer Wasser-Ethylenglykol-Mischung besteht.

4. Temperatursteuersystem nach Anspruch 1, 2 oder 3, umfassend ein Steuergerät (140) in Kommunikation mit mindestens dem einen von der Fluidheizeinrichtung, der Pumpe, dem Ventilator, einem ersten Ventil (230a) in dem ersten Strömungskreislauf und einem zweiten Ventil (230b) in dem zweiten Strömungskreislauf.

5. Temperatursteuersystem nach einem der vorhergehenden Ansprüche, wobei die Fluidheizeinrichtung einen elektrischen Tauchsieder (212) umfasst.

6. Temperatursteuersystem nach einem der vorhergehenden Ansprüche, wobei der erste Teil mindestens zwei darin angeordnete Platten aufweist, die operativ parallel miteinander gekoppelt sind und einen Strömungskanal zwischen benachbarten Platten ausbilden.

7. Temperatursteuersystem nach einem der vorhergehenden Ansprüche, wobei die Wärmequelle ein Leistungselektronikpaket umfasst.

8. Temperatursteuersystem nach Anspruch 7, wobei das Leistungselektronikpaket mindestens eines von einer Leistungshalbleitervorrichtung, einem Wandler, einem Wechselrichter, einer Batterie und einer Brennstoffzelle umfasst.

9. Transportkühlsystem (20), umfassend:
einen Kompressor (50), der eine Ansaugöffnung (53) und eine Auslassöffnung (51) aufweist und konfiguriert ist, um ein Kühlströmungskreislauf-Arbeitsfluid durch einen Kühlströmungskreislauf zu zirkulieren;
einen Wärmeaufnahme-Wärmetauscher (60), der operativ mit der Kompressorauslassöffnung gekoppelt ist; und
ein Temperatursteuersystem nach einem der vorhergehenden Ansprüche, wobei der Kühler benachbart zu dem Ventilator ist.

10. Verfahren zum Regulieren der Temperatur einer Wärmequelle, wobei das Verfahren umfasst:
operatives Koppeln eines Verdampfers (150), der ein erstes Arbeitsfluid zirkuliert, mit einem Temperatursteuersystem (200), das eine Fluidheizeinrichtung (210), die operativ mit einer Pumpe (220) gekoppelt ist, zum Zirkulieren eines zweiten Arbeitsfluids in einem ersten Strömungskreislauf (201a) und einem zweiten Strömungskreislauf (201b) und ein Steuergerät (140) umfasst, das eine Vielzahl von darin gespeicherten Grenzwerten oder Bereichen zum Betreiben des Temperatursteuersystems aufweist;
operatives Koppeln einer Wärmeübertragungseinrichtung (240) mit dem zweiten Strömungskreislauf, wobei die Wärmeübertragungseinrichtung einen ersten Teil (240a), einen zweiten Teil (240b) und eine Wärmesenke (245) umfasst, die zwischen dem ersten Teil und dem zweiten Teil der Wärmeübertragungseinrichtung (240) angeordnet ist, die eine Wärmequelle umfasst;
Betreiben des Steuergeräts, um das zweite Arbeitsfluid in dem ersten Strömungskreislauf zu zirkulieren und die Temperatur des zweiten Arbeitsfluids innerhalb eines vorbestimmten Temperaturbereichs aufrechtzuerhalten, der eine Obergrenze und eine Untergrenze aufweist;
Betreiben des Steuergeräts, um das zweite Arbeitsfluid in dem zweiten Strömungskreislauf zu zirkulieren und Wärme von dem zweiten Arbeitsfluid an mindestens eine von der Wärmeübertragungseinrichtung und der Wärmequelle abzugeben, wenn die Temperatur von mindestens einem von dem zweiten Arbeitsfluid und der Umgebungsluft kleiner als ein vorbestimmter unterer Temperaturgrenzwert ist;
Betreiben des Steuergeräts, um das zweite Arbeitsfluid in dem zweiten Strömungskreislauf zu zirkulieren, um Wärme von mindestens einer von der Wärmequelle und der Wärmeübertragungseinrichtung an das zweite Arbeitsfluid abzugeben, wenn die Temperatur des zweiten Arbeitsfluids größer als ein vorbestimmter Umgebungsluft-Temperaturgrenzwert ist; und
Betreiben des Steuergeräts, um das zweite Arbeitsfluid in dem ersten Strömungskreislauf zu zirkulieren, um Wärme von dem zweiten Arbeitsfluid an mindestens einen von dem Verdampfer und einem Frachtraum abzugeben, wenn mindestens ein vorbestimmter Betriebsbedingungsgrenzwert überschritten wird.

11. Verfahren nach Anspruch 10, wobei das Steuergerät eine elektrische Heizung (212) betreibt, wenn die Temperatur des zweiten Arbeitsfluids kleiner als die Untergrenze eines vorbestimmten Temperaturbereichs ist.

12. Verfahren nach Anspruch 11, wobei das Steuergerät betrieben wird, um dem zweiten Arbeitsfluid zu ermöglichen, Wärme an den Verdampfer abzugeben, und die elektrische Heizung auszuschalten, wenn die Temperatur des zweiten Arbeitsfluids größer als die Obergrenze des vorbestimmten Temperaturbereichs ist.

13. Verfahren nach Anspruch 10, 11 oder 12, wobei das Steuergerät einen Ventilator (260) betreibt, um Wärme von dem zweiten Arbeitsfluid abzugeben, wenn die Temperatur des zweiten Arbeitsfluids größer als ein vorbestimmter oberer Temperaturgrenzwert von mindestens einem von Umgebungsluft und einem Reservoir (211) ist.

14. Verfahren nach einem der Ansprüche 10 bis 13, wobei der vorbestimmte Betriebsbedingungsgrenzwert aus einer Gruppe ausgewählt ist, die aus einem Frachtraumtemperaturgrenzwert, einem Verdampferschlangentemperaturgrenzwert, einem Verdampferluftdruckgrenzwert oder einem Zeitlimit besteht.

## Revendications

1. Système de régulation de température (200) comprenant :
un dispositif de chauffage de fluide (210) couplé en fonctionnement à une pompe (220) configurée pour faire circuler un fluide de travail du système de régulation de température par un premier circuit d'écoulement (201a) et un deuxième circuit d'écoulement (201b),
dans lequel le premier circuit d'écoulement (201a) est couplé fluidiquement à un échangeur de chaleur d'absorption de chaleur (150), et
dans lequel le deuxième circuit d'écoulement (201b) est couplé fluidiquement à un dispositif de transfert de chaleur (240) comprenant une première portion (240a), une deuxième potion (240b), et un dissipateur thermique (245) disposé entre la première portion et la deuxième portion, la deuxième portion (240b) du dispositif de transfert de chaleur (240) comprenant une source de chaleur, et dans lequel le deuxième circuit d'écoulement (201b) est couplé fluidiquement à un radiateur (250) qui est couplé fluidiquement à un ventilateur (260).

2. Système de régulation de température selon la revendication 1, dans lequel l'échangeur de chaleur d'absorption de chaleur comprend un fluide frigorigène en circulation.

3. Système de régulation de température selon la revendication 1 ou 2, dans lequel le fluide de travail du système de régulation de température comprend un composé organique, sélectionné dans un groupe consistant en un mélange eau-propylène glycol ou un mélange eau-éthylène glycol.

4. Système de régulation de température selon la revendication 1, 2 ou 3, comprenant un contrôleur (140) en communication avec l'au moins l'un du dispositif de chauffage de fluide, de la pompe, du ventilateur, d'une première vanne (230a) dans le premier circuit d'écoulement et d'une deuxième vanne (230b) dans le deuxième circuit d'écoulement.

5. Système de régulation de température selon l'une quelconque des revendications précédentes, dans lequel le dispositif de chauffage de fluide comprend un chauffage électrique à immersion (212).

6. Système de régulation de température selon l'une quelconque des revendications précédentes, dans laquelle au moins deux plaques sont disposées dans la première portion et sont couplées en fonctionnement ensemble en parallèle, formant un canal d'écoulement entre des plaques adjacentes.

7. Système de régulation de température selon l'une quelconque des revendications précédentes, dans lequel la source de chaleur comprend un module d'électronique de puissance.

8. Système de régulation de température selon la revendication 7, dans lequel le module d'électronique de puissance comprend au moins l'un d'un dispositif semi-conducteur de puissance, d'un convertisseur, d'un onduleur, d'une batterie, et d'une pile à combustible.

9. Système de réfrigération de transport (20) comprenant :
un compresseur (50) ayant un orifice d'aspiration (53) et un orifice de refoulement (51) configuré pour faire circuler un fluide de travail du circuit d'écoulement de réfrigération à travers un circuit d'écoulement de réfrigération ;
un échangeur de chaleur d'absorption de chaleur (60) couplé en fonctionnement à l'orifice de refoulement du compresseur ; et un système de régulation de température tel que revendiqué dans l'une quelconque des revendications précédentes, dans lequel le radiateur est adjacent au ventilateur.

10. Procédé de régulation de la température d'une source de chaleur, le procédé comprenant les étapes consistant à :
coupler en fonctionnement un évaporateur (150) faisant circuler un premier fluide de travail, à un système de régulation de température (200) comprenant un dispositif de chauffage de fluide (210) couplé en fonctionnement à une pompe (220), pour faire circuler un deuxième fluide de travail dans un premier circuit d'écoulement (201a) et un deuxième circuit d'écoulement (201b), et un contrôleur (140) ayant stockée en son sein une pluralité de limites ou de plages pour faire fonctionner le système de régulation de température ;
coupler en fonctionnement un dispositif de transfert de chaleur (240) au deuxième circuit d'écoulement, le dispositif de transfert de chaleur comprenant une première portion (240a), une deuxième portion 240b), et un dissipateur thermique (245) disposé entre la première portion et la deuxième portion du dispositif de transfert de chaleur (240) comprenant une source de chaleur ;
faire fonctionner le contrôleur pour faire circuler le deuxième fluide de travail dans le premier circuit d'écoulement et pour maintenir la température du deuxième fluide de travail dans une plage de température prédéterminée ayant une limite supérieure et une limite inférieure ;
faire fonctionner le contrôleur pour faire circuler le deuxième fluide de travail dans le deuxième circuit d'écoulement et pour rejeter la chaleur du deuxième fluide de travail vers au moins l'un du dispositif de transfert de chaleur et de la source de chaleur, lorsque la température d'au moins l'un du deuxième fluide de travail et de l'air ambiant est inférieure à une limite de température inférieure prédéterminée ;
faire fonctionner le contrôleur pour faire circuler le deuxième fluide de travail dans le deuxième circuit d'écoulement pour rejeter la chaleur d'au moins l'un de la source de chaleur et du dispositif de transfert de chaleur vers le deuxième fluide de travail lorsque la température du deuxième fluide de travail est supérieure à une limite de température d'air ambiant prédéterminée ; et
faire fonctionner le contrôleur pour faire circuler le deuxième fluide de travail dans le premier circuit d'écoulement pour rejeter la chaleur du deuxième fluide de travail vers au moins l'un de l'évaporateur et d'un compartiment de chargement, lorsque au moins une limite de condition de fonctionnement prédéterminée est dépassée.

11. Procédé selon la revendication 10, dans lequel le contrôleur fait fonctionner un chauffage électrique (212) lorsque la température du deuxième fluide de travail est inférieure à la limite inférieure d'une plage de température prédéterminée.

12. Procédé selon la revendication 11, dans lequel le contrôleur fait fonctionner de manière à permettre au deuxième fluide de travail de rejeter la chaleur vers l'évaporateur, et à éteindre le chauffage électrique, lorsque la température du deuxième fluide de travail est supérieure à la limite supérieure de la plage de température prédéterminée.

13. Procédé selon la revendication 10, 11 ou 12, dans lequel le contrôleur fait fonctionner un ventilateur (260) pour rejeter la chaleur du deuxième fluide de travail lorsque la température du deuxième fluide de travail est supérieure à une limite de température supérieure prédéterminée d'au moins l'un de l'air ambiant et d'un réservoir (211).

14. Procédé selon l'une quelconque des revendications 10 à 13, dans lequel la limite de condition de fonctionnement prédéterminée est sélectionnée dans un groupe consistant en une limite de température de compartiment de chargement, une limite de température de serpentin d'évaporateur, une limite de pression d'air d'évaporateur, ou une limite de temps.
